# EUROPÄISCHE PATENTANMELDUNG

(11) **EP 1 090 857 A2**
(43) Veröffentlichungstag der Anmeldung: **11.04.2001**
(21) Anmeldenummer: 00120709.1
(22) Anmeldetag: 22.09.2000
(51) Int. Cl.: B65G 1/10

(54) **Einrichtung für das Beladen und Entladen bei der Behandlung von plattenförmigen Gegenständen**

(30) Priorität: 07.10.1999 DE 19948131
(71) Anmelder: Gebr. Schmid GmbH & Co., D-72250 Freudenstadt (DE)
(72) Erfinder: Schmid, Dieter C., 72250 Freudenstadt (DE)
(74) Vertreter: Patentanwälte Ruff, Beier und Partner

(57) **Zusammenfassung**

Eine Einrichtung (1) für das Beladen und Entladen bei der Behandlung von plattenförmigen Gegenständen, insbesondere von Leiterplatten (5) und Formätzteilen, hat mindestens eine Speicheranordnung (2) mit mehreren, bezogen auf eine Stapelrichtung aufeinanderfolgenden Speicherplätzen (4) zur Aufnahme mindestens eines plattenförmigen Gegenstandes. Die Speicherplätze sind zwischen lose übereinanderliegenden, zur Bildung der Speicheranordnung stapelbaren Auflageelementen (6) gebildet, die jeweils eine kammartige Anordnung von Auflagearmen (13) und dazwischenliegende Durchbrechungen (14) haben, durch die die Transportorgane (24) einer Transporteinrichtung (20) in Stapelrichtung (3) hindurchführbar sind. Erfindungsgemäße Einrichtungen ermöglichen eine platzsparende Aufbewahrung der Gegenstände sowie ein Beladen oder Entladen von Behandlungsmaschinen im wesentlichen ohne durch Wechsel von Speicheranordnungen bedingte Produktionsunterbrechungen.

## Beschreibung

Die Erfindung betrifft eine Einrichtung für das Beladen und Entladen bei der Behandlung von plattenförmigen Gegenständen, insbesondere von Leiterplatten und Formätzteilen.

Bei der Behandlung von plattenförmigen Gegenständen, insbesondere von Leiterplatten und Formätzteilen, stellt sich das Problem, diese Gegenstände vor Beginn einer Behandlung, zwischen den einzelnen Verfahrensschritten einer Behandlung und/oder nach Beendigung einer Behandlung in geeigneter Weise zu lagern und ggf. zu transportieren. Einrichtungen hierfür sollen einerseits eine sichere Lagerung der Gegenstände gewährleisten und andererseits ein schnelles Be- und Entladen ermöglichen, um ggf. Zeitverluste im Produktionsbetrieb zu vermeiden. Diese Manipulationen können besonders bei hochempfindlichen Gegenständen, wie Leiterplatten und Formätzteilen, kritisch sein, die teilweise so dünn und flexibel wie Blätter oder Folien sind, und die meist auch empfindliche Oberflächen haben.

Eine bekannte Einrichtung, die zum Transport von Leiterplatten von Maschine zu Maschine bzw. innerhalb einer Bearbeitungsmaschine zwischen einzelnen Stationen genutzt werden kann, hat ein Gestell, in dem eine Kassette mit einer darauf befindlichen Palette untergebracht ist, auf der die Leiterplatten, ggf. mit Zwischenlagen aus Papier o. dgl., aufeinanderliegend gestapelt liegen. Durch eine auf geeigneter Höhe angeordnete Transporteinrichtung mit Saugern werden sie abgenommen. Entsprechend dem Abnahmefortschritt wird die Palette so hochgetaktet, daß die nächste Leiterplatte in den Arbeitsbereich der Sauger gelangt. Wenn die Palette leer ist, muß sie im Eilgang heruntergefahren werden, um entnommen und durch eine neue, gefüllte Palette ersetzt zu werden. Dies bringt Produktionsunterbrechungen. Außerdem ist die Stapelung mit aufeinanderliegenden Leiterplatten o. dgl. für viele, insbesondere empfindliche Leiterplatten nicht geeignet.

Andere Einrichtungen, die dieses Problem vermeiden, haben Kassetten oder Magazine mit einer fest vorgebenen Anzahl einzelner, in der Regel übereinander liegender Speicherplätze, die meist jeweils einen plattenförmigen Gegenstand aufnehmen können. Zur Beschickung und Entleerung von Speicherplätzen kann eine Transporteinrichtung mit einem Bandausleger o. dgl. vorgesehen sein, der in die einzelnen Speicherplätze von einer seitlichen Öffnung her eingreift, wobei sowohl die Beschickung, als auch die Entnahme durch diese Öffnung erfolgt. Die Bewegungsabläufe zwischen Speicheranordnung und Transporteinrichtung beim Wechsel zwischen Speicherplätzen sind kompliziert.

Eine andere Einrichtung mit einer kassettenartigen Speicheranordnung ist in der EP 0 602 415 gezeigt. Bei dieser sind Transportorgane zur Beschickung und Entleerung von Speicherplätzen in die Speicheranordnung integriert, wobei vorzugsweise jedem Speicherplatz einzeln antreibbare Transportorgane in Form von geeigneten Wellen zugeordnet sind, die durch einen externen beim Be- oder Entladevorgang ankuppelbaren Antrieb angetrieben werden. Dadurch ist eine sehr schonende Manipulation der Gegenstände möglich. Außerdem ist eine Beschickung und Entleerung der Speicherplätze in beliebiger Reihenfolge möglich. Durch die Integration von Transportorganen in die Speicheranordnung ist jedoch deren Aufbau relativ aufwendig.

Ein Nachteil herkömmlicher Kassetten oder Magazine macht sich insbesondere dann bemerkbar, wenn unterschiedliche Losgrößen plattenförmiger Gegenstände zu handhaben sind. Denn sobald eine Losgröße, also eine Anzahl identisch zu behandelnder Gegenstände, von der Zahl der in einem Magazin vorhandenen Speicherplätze oder einem ganzzahligen Vielfachen davon abweicht, werden bei einem Magazin Speicherplätze nicht benutzt und bleiben leer. Der Transport und insbesondere die längerfristige Aufbewahrung von nur teilweise gefüllten Magazinen ist jedoch unökonomisch und besonders aus Platzgründen möglichst zu vermeiden. Zur Abmilderung dieser Probleme können Standardmagazine mit unterschiedlichen Speicherplatzzahlen von beispielsweise 10, 15 und 20 vorgehalten werden, um die Zahl verfügbarer Speicherplätze möglichst genau an die Zahl der Gegenstände eines Loses anzupassen. Auch die Bevorratung von Magazinen unterschiedlicher Aufnahmekapazität ist jedoch sowohl aus Kostengründen, als auch aus Platzgründen nachteilig.

Der Erfindung liegt die Aufgabe zugrunde, eine mit Speicherplätzen ausgestattete Einrichtung der genannten Art zu schaffen, die die beschriebenen Nachteile vermeidet. Insbesondere soll eine platzsparende Unterbringung der Gegenstände ermöglicht werden und es sollen Be- und Entladevorgänge schnell und zuverlässig sowie für die Gegenstände schonend durchführbar sein.

Diese Aufgabe wird gelöst durch eine Einrichtung mit den Merkmalen von Anspruch 1. Bevorzugte Weiterbildungen sind in den abhängigen Ansprüchen angegeben. Die Merkmale sämtlicher Ansprüche werden durch Bezugnahme zum Inhalt der Beschreibung gemacht werden.

In dieser Anmeldung wird entsprechend der Branchenübung als "Beladen" derjenige Vorgang bezeichnet, bei dem eine Behandlungsmaschine bzw. eine Arbeitsstation einer derartigen Maschine beschickt wird. Der Beladevorgang geht mit einer Entnahme eines plattenförmigen Gegenstandes aus einer Speicheranordnung, also mit einer teilweisen oder vollständigen Entleerung eines Speicherplatzes, einher. Entsprechend ist das Entladen einer Behandlungsmaschine mit der Beschickung bzw. Füllung von Speicherplätzen einer Speicheranordnung verbunden.

Bei einer erfindungsgemäßen Einrichtung hat eine Speicheranordnung mehrere bezogen auf eine Stapelrichtung aufeinanderfolgende Speicherplätze bzw. -fächer zur Aufnahme jeweils mindestens eines plattenförmigen Gegenstandes, wobei die Speicherplätze in der Regel vertikal übereinander liegen und im wesentlichen gleiche Dimensionen haben. Die Speicheranordnung hat mehrere von der Speicheranordnung und/oder voneinander lösbare Auflagen, die derart anordenbar sind, daß zwischen in Stapelrichtung aufeinanderfolgenden Auflagen ein Speicherplatz gebildet ist. Eine "Auflage" im Sinne dieser Anmeldung ist ein- oder mehrteiliger Auflageelement, auf das ein plattenförmiger Gegenstand aufgelegt werden kann und das den Gegenstand trägt bzw. unterstützt. Bei einer erfindungsgemäßen Speicheranordnung kann also durch Wegnahme bzw. Hinzufügen von einer oder mehreren lösbaren Auflagen die Speicherplatzzahl auf einfache Weise variiert werden. Vorzugsweise sind Auflagen ohne Zuhilfenahme von Werkzeugen von der Stapelanordnung lösbar bzw. an dieser anbringbar. Insbesondere kann die Zahl der Auflagen bzw. Speicherplätze an die Losgröße der jeweils auf zunehmenden Gegenstände angepaßt werden, so daß keine Leerplätze bzw. ungenutzten Speicherplätze mehr auftreten müssen. Es sind also Speicheranordnungen mit variabler und an die Erfordernisse mühelos anpassbarer Aufnahmekapazität geschaffen. Mit erfindungsgemäßen Speicheranordnungen ist sowohl der Transport, als auch die gegebenenfalls längerfristige Aufbewahrung plattenförmiger Gegenstände auf besonders ökonomische, platzsparende Weise möglich, da erfindungsgemäße Speicheranordnungen jeweils eine durch die Zahl der aufgenommenen Gegenstände bestimmte Minimalgröße haben können.

Eine bevorzugte Weiterbildung sieht vor, daß die Auflagen zur Bildung einer im wesentlichen ausschließlich aus den Auflagen bestehenden Speicheranordnung aufeinander stapelbar ausgebildet sind. Die Auflagen können insbesondere nach Art von stapelbaren Tablettes ausgebildet sein. Es kann sich um in sich stabile bzw. verwindungsteife Auflagen handeln, die derart geformt sind, daß zwischen aufeinanderliegenden Auflagen ein Speicherplatz gebildet wird. Hierzu können, insbesondere in den Randbereichen der Auflagen oder Tablettes, geeignete Abstandhalter oder geeignet angeformt Abstandhalterabschnitte vorgesehen sein. Zwar ist es auch möglich, die Speicheranordnung dadurch zu bilden, daß mehrere Auflagen lösbar an einem gemeinsamen Träger befestigt werden. Die Lösung mit stapelbaren Auflagen hat demgegenüber jedoch den großen Vorteil, daß eine derartige Speicheranordnung nach Wegnahme der letzten Auflage "rückstandsfrei verschwindet" und daß die Stapelanordnungshöhe ausschließlich durch die Einzelhöhe und die Zahl der Auflagen bestimmt ist. Eine vorteilhafte Weiterbildung sieht vor, daß die Auflagen Fixierungseinrichtungen zur gegenseitigen Fixierung aufeinanderliegende Auflagen gegen Relativverschiebung quer zur Stapelrichtung aufweisen. Hierzu können im Bereich der Fixierung jeweils komplementäre Gestaltungen übereinanderliegender Auflagen vorgesehen sein, die z. B. einen in Querrichtung wirkenden Formschluß zwischen übereinanderliegenden Auflagen herstellen. Durch die Fixiereinrichtungen ist die Bildung stabiler Stapel möglich, bei denen die gestapelten Auflagen auch bei Querbeschleunigungen, wie sie beispielsweise beim Transport auftreten, nicht gegeneinander verrutschen. Zwar kann eine kraftschlüssige Fixierung ausreichen, jedoch sind bevorzugt in Querrichtung formschlüssig wirkende Fixiereinrichtungen vorgesehen, beispielsweise in Form von an einer Auflage vorgesehenen Stiften, Noppen oder dergleichen die in entsprechende Ausnehmung an der jeweils anderen Auflage in Stapelrichtung eingreifen.

In Weiterbildung kann vorgesehen sein, daß die Auflagen Zentriereinrichtungen zur gegenseitigen Zentrierung aufeinanderliegender Auflagen aufweisen. Damit ist eine positionsgenaue Stapelung der Auflagen möglich, auch wenn die zur Stapelung vorgesehenen Einrichtungen eine nur mäßige Positioniergenauigkeit aufweisen. Diese wird durch die Selbstzentrierung der Auflagen kompensiert. Die Zentriereinrichtungen können mindestens einen an einer Auflage vorgesehenen Zentriervorsprung aufweisen, der zum Zusammenwirken mit einer Zentrieröffnung der jeweils benachbarten Auflage ausgebildet ist. Beispielsweise kann der Zentriervorsprung konisch oder kegelstumpfförmig ausgebildet sein und mit einer konischen oder kegelstumpfförmigen Zentrierausnehmung zusammenwirken.

Mit lösbaren Auflagen, die insbesondere zum gegenseitigen Aufeinanderstapeln ausgebildet sind, ist es auch möglich, Speicherplätze mit einer veränderlichen Größe, insbesondere mit veränderlicher Höhe zu schaffen, wozu insbesondere der Abstand benachbarter Auflagen veränderbar ist. Dies ermöglicht eine besonders platzsparende Unterbringung plattenförmiger Gegenstände, indem beispielsweise die Speicherplätze nur zur Beschickung oder Entleerung auf eine Be- und Entladehöhe erweitert werden und ansonsten ihre Minimalgröße annehmen können, die zweckmäßig die Höhe und gegebenenfalls das Ausholvolumen der auf zunehmenden Gegenstände nur so wenig übersteigt, daß eine gegebenenfalls empfindliche Oberfläche des plattenförmigen Gegenstandes nicht von einer darüberliegenden Auflage berührt wird. Dadurch kann eine besonders hohe Packungsdichte bei der Lagerung und beim Transport erreicht werden, ohne daß die Beschickung oder Entleerung der Speicherplätze durch ihre kleinen Dimensionen behindert wird. Die beschriebene Minimalgröße der Speicherplätze ist insbesondere auch dann nutzbar, wenn eine Speicheranordnung von ihren bezogen auf die Stapelrichtung äußeren Enden, also von oben oder von unten, durch Wegnahme von Auflagen abgearbeitet oder durch Hinzufügen von Auflagen erweitert wird, da eine Beschickung oder Entleerung einer Auflage jeweils in einem Zustand erfolgen kann, in dem diese ihren Minimalabstand zur darüberliegenden Auflage noch nicht oder nicht mehr hat. Eine vorzugswseise vorgesehene Einrichtung zum Anheben und Bewegen, insbesondere zum Anheben, und darauffolgenden seitlichen Wegbewegen von lösbaren Auflagen ist vorzugsweise derart ausgebildet, daß ein Randbereich einer Auflage durch die Einrichtung ergriffen oder untergriffen und anschließend die Auflage abgehoben werden kann. Ein vorzugsweise vorgesehener seitlicher Eingriff, der insbesondere von zwei gegenüberliegenden Seiten her erfolgen kann, ermöglicht das Abheben einzelner Tabletts oder ggf. auch das Abheben mehrerer übereinanderliegender Tabletts, um an jeder beliebigen Stelle der Speicheranordnung eine Trennung der Auflagen und/oder eine Vergrößerung eines Speicherplatzes zu bewirken. Je nach Erfordernissen kann eine Einrichtung beispielsweise bewegliche Greiforgane wie Greiffinger, für den Tablettrand haben oder auch soe ausgebildet sein, daß an die Tabletts angepaßte Auflageflächen durch seitliche Verschiebung unter entsprechende Vorsprünge am Rand der Auflagen eingreifen.

Ein Be- und Entladeverfahren unter Verwendung derartiger Einrichtungen und loser Auflagenstapel kann so ablaufen, daß die durch den Auflagenstapel gebildete Speicheranordnung unter einer Greifeinrichtung, beispielsweise einem Doppelgreifer plaziert wird, der die Tabletts an ihrem Rand ergreift, etwas abhebt und ggf. seitlich abführt und auf einem daneben angeordneten Stapel wieder ablegt. Nach dem Abheben können die Transportorgane einer geeigneten Transporteinrichtung die gespeicherten Gegenstände bequem erfassen und aus einem vergrößerten Speicherplatz abtransportieren.

Die Speicheranordnung ist vorzugsweise derart ausgebildet, daß mindesens ein Transportorgan einer der Speicheranordnung zugeordneten Transporteinrichtung zur Beschickung und Entleerung von Speicherplätzen in die Speicheranordnung einführbar ist. Die Speicheranordnung selbst braucht also keine integrierten Transportorgane zu haben, was einen einfachen Aufbau mit ggf. hoher Speicherdichte, d.h. hoher Anzahl speicherbarer Gegenstände bezogen auf das Volumen der Speicheranordnung, ermöglicht. Vorzugsweise ist das mindestens eine Transportorgan im eingeführten Zustand durch Relativbewegung von Stapelanordnung und Transporteinrichtung in Stapelrichtung zwischen Speicherplätzen bewegbar.

Die in der Regel mehreren Transportorgane müssen also zur Bewegung von einem Speicherplatz zu einem anderen Speicherplatz nicht aus dem ersten Speicherplatz herausgenommen, außerhalb der Speicheranordnung relativ zu dieser bewegt und anschließend in den nächsten Speicherplatz eingeführt werden, sondern es ist ein direkter Bewegungsweg innerhalb der Speicheranordnung möglich. Dadurch kann die Geschwindigkeit, mit der aufeinanderfolgend mehrere Speicherplätze beschickt oder entleert werden können, im Vergleich zu herkömmlichen Einrichtungen erheblich erhöht werden. Weiterhin kann sowohl der apparative, als auch der steuerungstechnische Aufwand verringert werden, da zur Bewegung von Transportorganen von einem Speicherplatz zum nächsten Speicherplatz lediglich eine Relativbewegung parallel zur Stapelrichtung erforderlich ist, während beispielsweise horizontale Vor- und Zurückbewegungen der Transportorgane und/oder der Speicheranordnung nicht erforderlich sind.

Die durch diese Weiterbildung geschaffene Möglichkeit, Transportorgane in Stapelrichtung ggf. vollständig durch die Stapelanordnung hindurchzufahren, ermöglicht es auch, daß gefüllte bzw. entleerte Speicheranordnungen, Auflagengruppen oder Einzelauflagen an unterschiedlichen Stellen z.B. oberhalb oder unterhalb eines Transportorganbereiches anfallen und gesondert zugeführt bzw. entnommen werden können. So muß beispielsweise eine Speicheranordnung, wenn sie leer ist, nicht mehr in die Anfangsstellung zurückgefahren werden, um ausgetauscht zu werden, sondern sie kann sofort durch eine neue Speicheranordnung oder eine Auflagegruppe oder durch einzelne Auflagen ersetzt werden, ohne daß es zu einer Produktionsunterbrechung kommen muß. Durch eine Zufuhr unmittelbar aufeinanderfolgender Speicheranordnungen, Auflagengruppen oder Einzelauflagen ist also eine quasi pausenlose bzw. kontinuierliche Beschickung bzw. Entleerung von Speicherplätzen möglich, wobei die Zahl der genutzten Speicherplätze wesentlich größer sein kann als die Zahl der in einer einzigen Speicheranordnung vorhandenen Speicherplätze.

Die Relativbewegung zwischen Speicheranordnung und Transportorgan wird vorzugsweise durch insbesondere taktweise Bewegung der Stapelanordnung in Stapelrichtung, also normalerweise vertikal, herbeigeführt, wofür eine entsprechende Bewegungseinrichtung, insbesondere eine Hub- und Senkeinrichtung vorgesehen sein kann. Dadurch kann die Transportorgananordnung bzgl. ihrer Höhe festgelegt sein, was eine besonders einfache Verbindung zu der zu beladenden oder zu entladenden Maschine ermöglicht. Alternativ oder zusätzlich wäre auch eine Bewegung von Transportorganen parallel zur Stapelrichtung möglich.

Die beschriebene Relativbewegung von Speicheranordnung und Transportorganen wird zweckmäßig dadurch erreicht, daß einem Speicherplatz eine quer, insbesondere senkrecht zur Stapelrichtung ausgerichtete Auflage für mindestens einen plattenförmigen Gegenstand zugeordnet ist und daß die Auflage mindestens eine in Stapelrichtung durchgehende Durchbrechung oder Aussparung zur Durchführung mindestens eines Transportorganes hat. Dieses kann beispielsweise bei Hindurchführen von unten nach oben einen auf der Auflage aufliegenden, die Durchbrechung überspannenden Gegenstand von der Auflage abheben und anschließend seitlich, d.h. horizontal, wegbewegen. Vorzgusweise sind die Durchbrechungen zu mindestens einer Seite der Auflage offen, so daß Transportorgane einer seitlich zur Stapelanordnung angeordneten Transporteinrichtung von der Seite in die Stapelanordnung eingreifen können.

Besonders vorteilhaft sind Ausführungen, bei denen die Auflagen mit kammartig angeordneten, an einem Ende untereinander verbundenen Auflagearmen ausgestattet sind, zwischen denen langgestreckte Durchbrechungen zur Hindurchführung von vorzugsweise langgestreckten Transportorganen liegen. Zur mechanischen Stabilisierung der vorzugsweise aus säurebeständigem Material, wie Edelstahl bestehenden, frei abragenden Arme können diese einen der Versteifung dienenden, profilierten Querschnitt haben, der bevorzugt flach rechteckförmig mit abgerundeten Kanten sein kann. Dadurch kann gleichzeitig eine aus Gründen der schonenden Lagerung vorteilhafte Abrundung von Kanten der Auflagearme geschaffen werden.

Zur Steigerung der Flexibilität bei Beschickung und Entleerung der Speicheranordnung kann vorgesehen sein, daß die vorzugsweise im wesentlichen rechtwinklig begrenzten Speicherplätze an mindestens zwei vorzugsweise gegenüberliegenden Seiten, insbesondere an drei Seiten offen oder zur Einführung und Entnahme plattenförmiger Gegenstände öffenbar sind. Eventuell vorgesehene Abstandhalter können so plaziert sein, daß sie der Beschickung und Entleerung der Speicherplätze nicht behindern.

Eine geeignete Transporteinrichtung kann eine Anordnung von Transportorganen haben, die derart komplementär zu den Durchbrechungen der Auflagen angeordnet sind, daß die Speichereinrichtung und die Transporteinrichtung bzw. deren Transportorgane unter Hindurchführung der Transportorgane durch die Durchbrechungen in Stapelrichtung relativ zueinander bewegbar sind. Entsprechend kann eine zur Zusammenarbeit mit kammartig geformten Auflagen vorgesehene Transporteinrichtung mindestens eine Transportorgananordnung mit kammartig angeordneten, vorzugsweise parallel mit Abstand zueinander verlaufenden Transportarmen haben. Mehrere Ausführungsformen werden im Zusammenhang mit den Zeichnungen näher erläutert.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte Ausführungen darstellen können.

Ausführungsbeispiele der Erfindung sind in den Zeichnungen dargestellt und werden im folgenden näher erläutert. In den Zeichnungen zeigen:
- Fig. 1: eine schematische Seitenansicht einer Ausführungsform einer erfindungsgemäßen, aus mehreren lose aufeinandergestapelten Auflageelementen bestehenden Speicheranordnung mit übereinanderliegenden Speicherplätzen für Leiterplatten sowie einer zur Bestückung und Entleerung der Speicherplätze vorgesehenen Transporteinrichtung mit einer horizontal beweglichen, gabelartigen Anordnung flacher Transportarme,
- Fig. 2: eine Speicheranordnung der in Fig. 1 gezeigten Art mit einer Transporteinrichtung, bei der eine kammartige Anordnung von Förderbändern in die Speicheranordnung einführbar ist.
- Fig. 3: eine Speicheranordnung der in den Figuren 1 und 2 gezeigten Art mit einer Transporteinrichtung, die eine kammartige Anordnung von in die Speicheranordnung einführbaren Transportrollen hat.
- Fig. 4: eine schematische Draufsicht auf die Speicheranordnung in Fig. 1 bis 3 in Stapelrichtung,
- Fig. 5: eine schrägperspektivische Darstellung von drei Auflagearmen einer Auflage der in den Fig. 1 bis 4 gezeigten Speicheranordnung mit Schnitt entlang der Linie V-V in Fig. 4,
- Fig. 6: eine Draufsicht auf die Einrichtung gemäß Fig. 2 mit einer auf einer Auflage liegenden, strichpunktiert umgrenzten Leiterplatte,
- Fig. 7: eine Draufsicht auf die Ausführungsform nach Fig. 3, Fig. 8 eine andere Ausführungsform einer Stapelanordnung mit lose aufeinanderliegenden, tablettartigen Auflagen in Vorderansicht und Draufsicht sowie bei der Beschickung und Entleerung,
- Fig. 9: eine oberhalb der Stapelanordnung aus Fig. 8 anordenbare Einrichtung zum Aufstapeln und Abstapeln tablettartiger Auflagen und
- Fig. 10: eine Detailansicht des umkreisten Bereichs X in Fig. 8 zur Darstellung des mit Abstandhaltern versehenen Randbereichs der tablettartigen Auflagen.

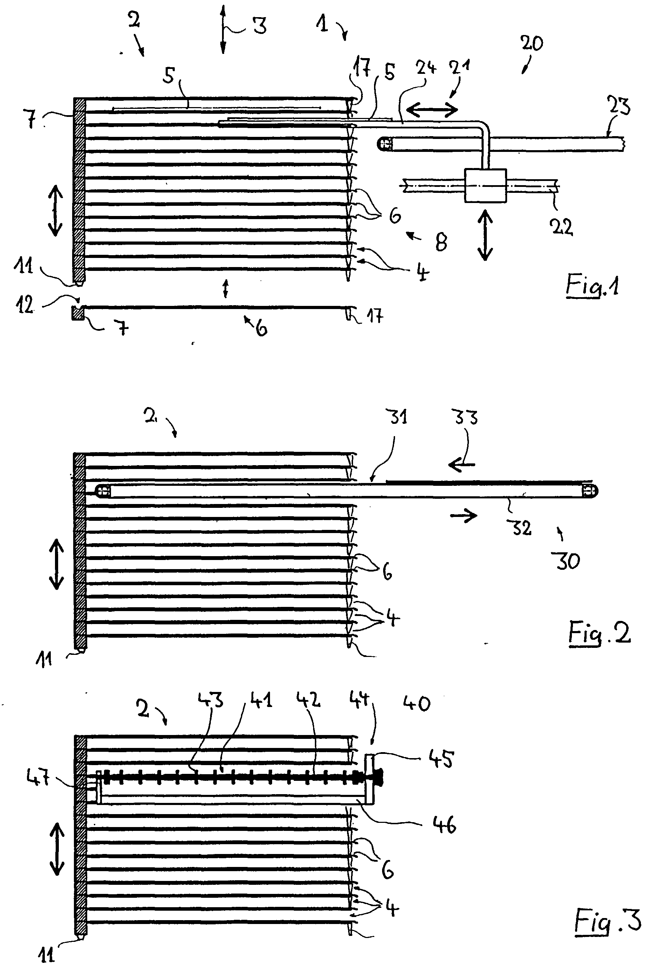

Die in Fig. 1 schematisch gezeigte Belade- und Entladeeinrichtung 1 ist dazu vorgesehen, Leiterplatten oder andere plattenförmige Gegenstände, die in einer nicht gezeigten Behandlungsstation behandelt, beispielsweise geätzt oder gereinigt wurden oder werden sollen, platzsparend auf zubewahren und bei Bedarf der Maschine oder einer entsprechenden Teileinrichtung zuzuführen oder von dieser aufzunehmen. Die Einrichtung hat eine Speicheranordnung 2 mit einer Vielzahl von z.B. vierzehn in Stapelrichtung 3 übereinander liegenden, im wesentlichen identisch dimensionierten Speicherplätzen oder Fächern 4 zur Aufnahme jeweils mindestens einer Leiterplatte 5. Die Speicheranordnung 2 besteht im wesentlichen aus mehreren, beispielsweise fünfzehn, identischen, in sich stabilen und weitgehend verwindungssteifen Auflageelementen 6, die unter Bildung einer Rückwand lose aufeinanderliegend angeordnet sind. Es wird zwischen jeweils zwei direkt übereinanderliegenden Auflagen 6 ein flacher, horizontaler Speicherplatz 4 geschaffen, der zur Rückwand geschlossen, zur Vorderseite 8 und den beiden einander gegenüberliegenden Seiten 9, 10 der quaderförmigen Anordnung dagegen weitgehend offen ist.

Die Auflageelemente 6 der Speicheranordnung 2 sind, anders als bei Kassetten oder Magazinen des Standes der Technik, nicht mechanisch fest miteinander verbunden, sondern ohne Zuhilfenahme von Werkzeugen voneinander lösbar. Sie bilden einen Stapel vum:Helbar aufeinander aufliegender Einzelauflagen. Dadurch wird es auf einfache Weise möglich, die Anzahl der Speicherplätze der Speicheranordnung durch Hinzufügen weiterer Auflagen zu vergrößern oder durch Wegnahme von Auflagen zu verkleinern und auf diese Weise z. B. der Losgröße zu behandelnden Gegenstände anzupassen. Die Auflageelemente sind so ausgebildet, daß sie sich durch Auseinanderziehen parallel zur Stapelrichtung leicht voneinander lösen lassen, während eine Relativverschiebung aufeinanderliegender Auflagen 6 durch geeignete Fixier- und Zentriereinrichtungen (siehe die beiden unteren Auflageelemente in Fig. 1) durch formschlüssigen Eingriff komplementärer Elemente dieser Einrichtungen zuverlässig verhindert wird.

Jede der Auflagen 6 hat eine Vielzahl von beispielsweise 7 mit gegenseitigem Seitenabstand parallel nebeneinander liegenden Auflagearmen 13, die in Fig. 1 schematisch als Flachelemente dargestellt sind, bei einer bevorzugten Ausführungsform jedoch durch Edelstahlrohre mit rechteckigem Querschnitt (Fig. 5) gebildet sind. Durch den hohlen Rechteckquerschnitt ist eine hervoragende mechanische Steifigkeit der von der Rückseite 7 im wesentlichen frei abragenden Arme 13 bei gleichzeitig relativ geringem Gewicht gewährleistet. Zudem sind im wesentlichen ebene Auflageflächen 16 für die aufzulegenden Gegenstände geschaffen, so daß diese mit geringem Flächendruck aufliegen können. Zumindest die oberen Längskanten der Arme 13 sind zweckmäßig abgerundet, so daß sie die zu sprechenden Gegenstände nicht verkratzen oder anderweitig beschädigen können. Die Tragarme 13 sind an ihren Hinterenden durch eine ebenfalls aus Edelstahlrohr fertigbare Querstrebe 7 fest miteinander verbunden, wobei die einzelnen Arme beispielsweise durch Anschrauben oder Anschweißen an der Querstrebe befestigbar sind.

Wie besonders gut bei den beiden unteren Auflageelemente von Fig. 1 zu erkennen ist, sind an der Unterseite jeder Querstrebe 7 zwei oder mehr voneinander beabstandete, nach unten abragende, kegelstumpfförmige Vorsprünge 11 vorgesehen, die bei aufeinanderliegenden Auflageelementen in entsprechend positionierte, komplementäre innenkonische Aufnahmeöffnungen 12 an der Oberseite der Auflage im Bereich der Querstrebe 7 eingreifen. Durch den in Querrichtung formschlüssigen Eingriff werden einerseits Relativverschiebungen aufeinanderliegende Auflagen quer zur Stapelrichtung 3 verhindert, so daß die Vorsprünge 11 und Öffnungen 12 als Fixiermittel gegen Verrutschen dienen. Durch die zusammenwirkende Konusflächen ist zusätzlich eine gegenseitige Zentrierung aufeinanderliegende Auflagen gewährleistet, so daß selbst bei nicht exakt positionierter oberer Auflage diese nach Absenken auf die darunterliegende Auflage positionsgenau liegt. Dadurch wirken die Vorsprünge 11 bzw. Öffnungen 12 gleichzeitig auch als Zentriereinrichtung für die Auflagen.

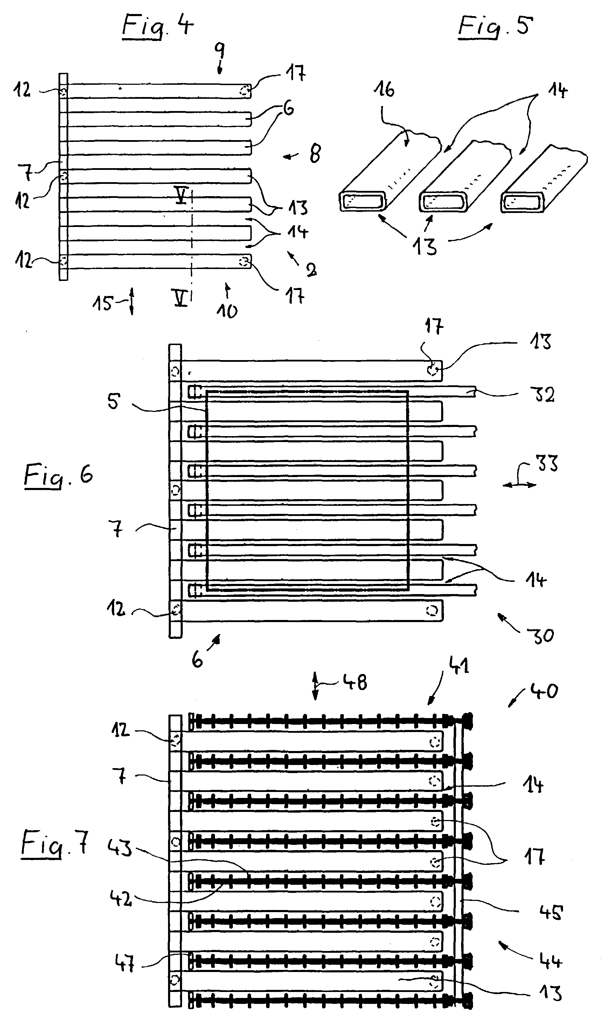

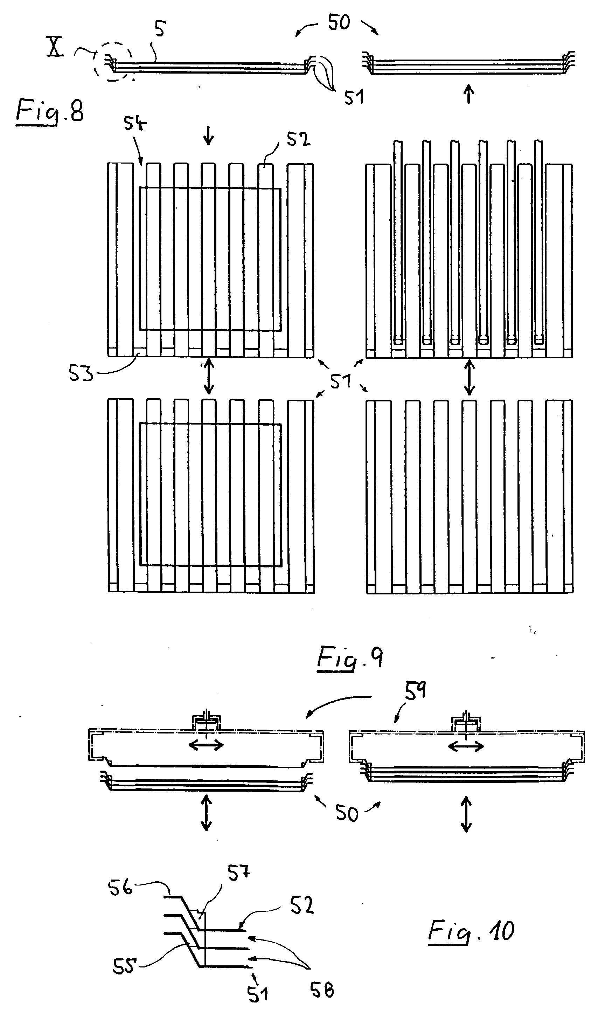

An den vorderen Endbereichen der beiden seitlichen Auflagearme können ebenfalls entsprechende Zentrier- und Fixiereinrichtungen vorgesehen sein, die gleichzeitig als Abstandhalter zwischen den übereinandenliegenden, im wesentlichen frei abragenden Armen 13 dienen können. In den Figuren 1 bis 4 sind Abstandhalter 17 schematisch gezeigt. Die Abstandhalter gewährleisten eine ausreichende Parallelität der übereinandenliegenden Auflagen sowie eine ausreichende Stabilität der gesamten Speicheranordnung. Die Abstandhalter 17 in Fig. 4 lingen in Querrichtung so weit auseinander, daß eine Einführung aufzunehmender Gegenstände zwischen den Abstandhaltern in Längsrichtung der Arme 6 möglich ist. Der freie Abstand zwischen Querstrebe 7 und Abstandhalter 17 ermöglicht auch einen Transport in Querrichtung 15 (Fig.17). Da die Auflagen voneinander lösbar sind, können ggf. einige oder alle Enden der zwischen den äußeren Auflagearmen liegenden Arme ebenfalls Abstandhalter aufweisen. In diesem Fall könnte zur Beschickung bzw. Entleerung eines Speicherplattes die jeweils obenliegende Auflage angehoben werden, so daß die Abstandhalter bei einem Transport in Längsrichtung der Arme nicht stören. Ein An- und Abtransport in Quernichtung der Arme, wie er im Zusammenhang mit Fig. 7 noch erläutert wird, wird durch Abstandhalter an den Enden der Auflagearme nicht behindert.

Durch die kammartige oder rechenartige Anordnung der an der Querstrebe 7 miteinander verbundenen Aufnahmearme 13 ist eine insgesamt etwa quadratische Auflage geschaffen, die zwischen den Auflagearmen in Stapelrichtung 3 durchgehende Durchbrechungen oder Ausnehmungen 14 hat, welche zur Vorderseite 8 der Stapelanordnung geöffnet sind. Durch die in Querrichtung 15 regelmäßige Abfolge von Auflagearmen mit streifenförmigen, ebenen Auflageflächen 16 ist sichergestellt, daß ein auf der Auflage liegender plattenförmiger Gegenstand an vielen relativ dicht beieinander liegenden und in Querrichtung gleichmäßig verteilten Auflagebereichen abgestützt wird, so daß eine schonende, verbiegungsfreie Lagerung auch von sehr dünnen, folienartig flexiblen Gegenständen, wie dünnen Leiterplatten, gewährleistet ist. Andererseits bieten die vorne offenen, langgestreckten Durchbrechungen 14 zwischen den Aufnahmearmen die Möglichkeit, daß Transportorgane geeignet angepaßter Transporteinrichtungen in die Speicheranordnung z.B. von unten eingeführt und zwischen den Auflagearmen 13 im Bereich der vertikal durchgehenden, durch die Durchbrechungen 14 gebildeten Kanäle im eingeführten Zustand durch Relativbewegung von Speicheranordnung und Transportorgan in Stapelrichtung 3 zwischen den Speicherplätzen 4 bewegbar sind.

In den Figuren 1 bis 3 sind verschiedene Ausführungsformen geeigneter Transporteinrichtungen schematisch dargestellt, wobei die in den Figuren 2 und 3 in Seitenansicht gezeigten Transporteinrichtungen in den Figuren 6 bzw. 7 in Draufsicht dargestellt sind. Die Ausführungsform einer Transporteinrichtung 20 in Fig. 1 hat eine Transportorgananordnung 21, die mit Hilfe einer vertikal verschiebbaren, horizontalen Linearführung 22 und geeigneter Antriebe in horizontaler Richtung zwischen der Speicheranordnung 2 und einem Förderband 23 der Transporteinrichtung hin- und herbewegbar ist. Das Förderband 23 sorgt, je nach Laufrichtung, für den Transport zwischen der zu be- oder entladenden Maschine und der Transportorgananordnung 21, während diese das Umsetzen der Leiterplatten o. dgl. zwischen Förderband und Speicheranordnung übernimmt. Die Transportorgananordnung 21 hat eine der Anzahl der Durchbrechungen 14 entsprechende Zahl von kammartig angeordneten, flachen Transportarmen 24, deren vertikale Dicke geringer als die Höhe der Speicherplätze sein kann und die derart komplementär zu den Auflagearmen 13 angeordnet sind, daß die Transportarme 24 mit den Auflagearmen 13 kämmen, wobei die Transportarme ohne Berührung der jeweils seitlich benachbarten Auflagearme zwischen diesen hindurchführbar sind.

In Fig. 1 ist ein bevorzugtes Verfahren zur Entleerung der Speicheranordnung 2 und damit zur Beladung der zugeordneten Maschine zeichnerisch dargestellt. Dabei wird die zunächst gefüllte Speicheranordnung zunächst in eine Ausgangsposition oberhalb der Ebene der Transportorgananordnung 21 verfahren derart, daß die vertikal durchgehenden Durchbrechungskanäle oberhalb der Arme 24 liegen. Anschließend wird die Speicheranordnung mittels einer nicht gezeigten Hub- und Senkeinrichtung so weit abgesenkt, bis der am weitesten unten liegende Gegenstand von seiner Auflage geringfügig abgehoben wird. In dieser Vertikalposition kann die Speicheranordnung angehalten und die Transportorgananordnung mit der nun auf den Armen 24 aufliegenden Leiterplatte zunächst horizontal nach vorne aus der Speicheranordnung herausgefahren und anschließend durch Absenken der Tragarmanordnung 21 auf dem vorzugsweise während des Auflegevorgangs stehenden Förderband 23 abgelegt werden. Hierbei ist zu beachten, daß auch die Förderbandanordnung 23 eine Vielzahl parallel nebeneinander liegender einzelner Förderbänder umfaßt, zwischen denen die Arme die Transportarmanordnung 21 beweglich sind. Nach Abtransport der Leiterplatte kann die Transportarmanordnung auf ihre vor Absenken auf das Förderband vorliegende Höhe zurückgefahren und horizontal in die Speicheranordnung eingeschoben werden. Durch taktweises Absenken der Speicheranordnung um den Vertikalabstand übereinanderliegender Gegenstände 5 kann dann der nächste Gegenstand abgehoben und im folgenden in der beschriebenen Weise aus der Speicheranordnung entnommen werden.

Eine Besonderheit des mit der beschriebenen Speicheranordnungen durchführbaren Verfahrens besteht darin, daß die zunächst gefüllte Speicheranordnung beispielsweise zunächst oberhalb der Transporteinrichtung horizontal antransportiert, dann zur Entladung durch eine geeignete Hub- bzw. Senkeinrichtung taktweise abgesenkt wird und nach Entleerung unterhalb der Transportanordnung liegt und sofort nach Entleerung, ohne Rücklauf in die Ausgangsposition, in beliebige Querrichtungen oder weiter nach unten abgeführt werden kann. Eine entleerte Speicheranordnung kann also sofort durch eine ggf. unmittelbar über ihr angeordnete, gefüllte Anordnung ersetzt werden, ohne daß es einer Unterbrechung des Beladevorgangs oder Entladevorgangs bedarf. Analoge Vorteile ergeben sich selbstverständlich bei der Beschickung von Speicheranordnungen, also bei der Entladung der zugeordneten Maschinen. Dabei wird zweckmäßig so verfahren, daß die Speicherplätze unter taktweiser Anhebung der Speicheranordnung nacheinander von oben nach unten befüllt werden. Die Abfuhr gefüllter Speicheranordnungen kann entsprechend in einen Bereich oberhalb der Transporteinrichtung wiederum in alle Querrichtungen oder nach oben erfolgen, während direkt von unten eine neue zu füllende Speicheranordnung nachführbar ist.

Dank der aufeinander stapelbaren Auflagen ist es auch möglich, nicht eine gesamte Stapelanordnung 2 als Ganzes an- und abzutransportieren, sondern es können auch Teilgruppen oder einzelne Auflageelemente horizontal herangeführt und an ein Ende der Speicheranordnung angedockt bzw. von einem Ende der Speicheranordnung abgelöst und quer zur Stapelrichtung abtransportiert werden. Hierdurch ist eine sich kontinuierlich regenerierende Speicheranordnung geschaffen, mit der ein kontinuierlicher Betrieb ohne Unterbrechungen möglich ist.

Eine nicht gezeigte Ausführungsform, die insbesondere für Gegenstände mit glatten und wenig empfindlichen Oberflächen geeignet ist, kann als Transportorgane Sauger haben, die an entsprechenden Trägern angeordnet sind und von der Oberseite der Gegenstände an diesen angreifen. Die Arbeitsweise derartiger Vorrichtungen wäre insofern unterschiedliche zur beschriebenen Abfolge, als dort die Abnahme von Gegenständen aus der Speicheranordnung von oben nach unten und entsprechend die Befüllung der Speicheranordnung von unten nach oben erfolgen würde. Bei Zugriff zu den Gegenständen von oben könnte dank der lösbaren Auflagen jeweils nach Abnehmen eines Gegenstandes die zugehörige Auflage entfernt werden, so daß der auf der nächsten, darunterliegenden Auflage liegende Gegenstand von oben frei zugänglich wird. Umgekehrt könnte eine Speicherfüllung erfolgen, indem jeweils auf die obenliegende Auflage ein Gegenstand gelegt wird und danach die darüberliegende Auflage aufgelegt wird usw..

Anhand der Figuren 2 und 6 wird eine Transporteinrichtung 30 erläutert, die eine auf fest vorgegebener Höhe installierte Transportorgananordnung 31 mit kammartig angeordneten, parallel mit Abstand zueinander verlaufenden, horizontalen Transportgliedern in Form von Förderbändern 32 hat. Die Förderbänder sind so schmal, daß sie ohne Berührung der Arme 13 in die langgestreckten Durchbrechungen 14 zwischen den Auflagearmen 13 passen, andererseits jedoch mit einer Breite, die mehr als die halbe lichte Weite der Durchbrechungen beträgt, so breit, daß sie großflächige, im wesentlichen ebene Auflageflächen für plattenförmige Gegenstände 5 bieten. Je nach Laufrichtung der Förderbänder wird eine Leiterplatte o. dgl. aus der Speicheranordnungt entnommen oder darin abgelegt. Durch die Förderbandanordnung 30 kann ein direkter Transport von Gegenständen zwischen der Speicheranorndung und der zu beladenden oder entladenden Maschine geschaffen werden, wozu die Länge der Förderbänder entsprechend angepaßt sein kann. Die Förderrichtung 33 der förderbandartigen Transportorgane verläuft parallel zur Längsrichtung der Aufnahmearme 13 bzw. zu den Durchbrechungen 14.

Bei der Transporteinrichtung 40 gemäß Figuren 3 und 7 ist eine auf fester vertikaler Höhe installierte Transportorgananordnung 41 vorgesehen, die eine Anzahl von z.B. acht parallelachsigen, horizontalen Walzen 42 aufweist, die von einem nicht gezeigten Antrieb der Transporteinrichtung gleichsinnig synchron drehend antreibbar sind. Die Walzen 42 stehen über in Längsrichtung gleichmäßig beabstandete Transportscheiben 43 jeweils mit der Unterseite eines zu transportierenden Gegenstandes an vielen regelmäßig und dicht verteilten Auflagestellen in Abrollkontakt, wobei die Flächendichte der Kontaktstellen zweckmäßig so groß gewählt ist, daß auch sehr dünne Leiterplatten im wesentlichen ohne Durchbiegung zwischen den Auflagestellen transportierbar sind. Die Walzen sind in einer Trägeranordnung 44 drehbar gelagert, die einen antriebsseitigen, stabilen Querträger 45 aufweist, der über jeweils unterhalb der Walzen verlaufende Längsträger 46 mit Lagerteilen 47 für das antriebsabgewandte Ende der Walzen verbunden ist. Auch hier ist also eine kammartige Transportorgananordnung vorgesehen, deren durch die Walzen gebildeten Transportarme mit den Auflagen 13 kämmen, wobei allerdings im Unterschied zur Ausführungsform nach Fig. 6 die Förderrichtung 48 quer, insbesondere senkrecht zur Ausrichtung der Auflagearme 13 verläuft. Diese Ausführungsform erfordert also eine zu den Seiten offene Speicheranordnung, während bei den Ausführungsformen nach Figuren 1 und 2 die Speicheranordnung auch Seitenwände haben kann. Derartige Quertransporteinrichtungen können besonders vorteilhaft mit Auflageelementen zusammenwirken, bei denen an mehreren bzw. an jedem Auflagearm ein Abstandhalter 17 vorgesehen ist, der dazu dient, sich an der jeweils darüberliegenden oder darunterliegenden Auflage abzustützen, um die frei abragenden Arme zu stabilisieren.

Ähnlich wie bei dem im Zusammenhang mit Fig. 1 beschriebenen Beschickungs- und Entleerungsverfahren wird auch bei den Ausführungsformen nach Figuren 2 und 3 vorzugsweise nur die Speicheranordnung vertikal vorzugsweise taktweise bewegt, während die Transporteinrichtungen auf fest vorgegebener Höhe installiert sein können. Dies vereinfacht den Aufbau der Transporteinrichtungen und erleichtert auch die Anbindung an die jeweils zu be- und entladenden Maschinen.

Anhand der Figuren 8 bis 10 wird eine andere Ausführungsform einer Speicheranordnung 50 erläutert, die durch mehrere leicht voneinander abnehmbare, nach Art von stapelbaren Tabletts ausgebildete Auflagen 51 gebildet oder zusammensetzbar ist. Jedes der in sich stabilen und verwindungssteifen Auflageelemente hat, ähnlich wie die Auflagen 6 der oben beschriebenen Ausführungsformen, eine kammartige Anordnung schmaler, langgestreckter Auflagearme 52. Diese sind an einem Längsende mittels einer Querstrebe 53 so untereinander verbunden, daß sie mit gegenseitigem Seitenabstand parallel zueinander liegen und zwischen sich Durchbrechungen 54 begrenzen, die auf der der Querstrebe 53 gegenüberliegenden Seite offen sind. An den seitlich außen liegenden Auflagearmen sind jeweils schräg nach außen und oben gerichtete Abschnitte 55 vorgesehen, die in einen horizontal abragenden, schmalen Randstreifen 56 übergehen. Im Innenwinkel zwischen dem horizontalen Auflagearm 52 und der Anschrägung 55 sind jeweils Abstandhalterelemente 57 angeordnet, deren Oberseite der Unterseite eines Tabletts so angepaßt ist, daß dieses im wesentlichen seitenspielfrei auf die Abstandhalter des darunter liegenden Tabletts auflegbar ist. Die Höhe der Abstandhalter ist so bemessen, daß zwischen Auflagearmen übereinanderliegender Tabletts ein als Speicherplatz 58 dienender, ggf. sehr flacher Zwischenraum 58 verbleibt. Zusätzlich zu den Abstandhaltern 57 können auch an den freien Enden der Auflagearme 52 entsprechende Abstandhalter vorhanden sein. Die Abstandhalter dienen im Zusammenwirken mit entsprechenden Gegenflächen der jeweils abragenden Auflage auch als Fixier- und Zentriereinrichtung zur Abrutschsicherung bzw. zur lagegenauen Positionierung der Auflageelemente aufeinander.

Ein Vorteil erfindungsgemäßer Speicheranordnungen ist, daß die Stapelung besonders platzsparend erfolgen kann. Auch ist es auf einfache Weise möglich, die Anzahl der Speicherplätze einer Speicheranordnung in weiten Grenzen beliebig einzustellen, indem eine entsprechende Anzahl von Tabletts übereinander gelegt wird. Zu erwähnen ist auch, daß durch die Erfindung Speicherplätze mit veränderlicher Höhe geschaffen werden können, indem der Abstand der lose aufeinanderliegenden Auflageelemente z.B. durch Abheben des jeweils oberen Elementes vergrößert wird. Insbesondere kann es so sein, daß ein gefüllter oder leerer Speicherplatz während Lagerung und Transport seine durch die Abstandhalterhöhe gegebene Minimalgröße hat, während zur bequemeren Beschickung bzw. Entleerung eines Speicherplatzes dessen Höhe durch vertikale Abstandsvergrößerung zwischen den den Speicherplatz vertikal begrenzenden Tabletts vergrößert wird. Dies kann durch Abheben des jeweils oberen Tabletts, Absenken des jeweils unteren Tabletts oder durch eine Kombination derartiger Vertikalbewegungen erfolgen, wobei ein Anheben des jeweils oberen Tabletts bei vertikal unbewegtem unteren Tablett bevorzugt ist.

Da es prinzipiell möglich ist, einen Auflagenstapel an jeder beliebigen Stelle zu trennen, können Speicherplätze bei dieser Ausführungsform selektiv und unabhängig vom Beladezustand benachbarter Speicherplätze beschickt oder entleert werden.

Die Entleerung oder Beschickung einer derartigen Speicheranordnung erfolgt vorzugsweise von vorne, also in Längsrichtung der Auflagearme, beispielsweise mittels der in den Figuren 1 oder 2 gezeigten Transporteinrichtungen, insbesondere über die Bandeinrichtung gemäß Fig. 2 bzw. 6. Die Entleerung eines gefüllten Stapels kann dabei von unten nach oben durchgeführt werden, indem bei vertikal festliegender Transporteinrichtung diese in die Durchbrechungen der Auflagen eingreift und der Auflagenstapel, vorzugsweise taktweise, abgesenkt wird. Sobald der zuunterst liegende Gegenstand durch die Fördereinrichtung etwas von der Auflage abgehoben ist, wird der Absenkvorgang angehalten und die direkt oberhalb liegende Auflage durch eine geeignete Greifeinrichtung 59 so weit abgehoben, daß die vergrößerte Speicherplatzhöhe für eine störungsfreie Abförderung des Gegenstandes aus dem Speicherplatz ausreicht. Nach Entleerung des Speicherplatzes wird das abgehobene Tablett bzw. der abgehobene Tablettstapel wieder abgesenkt und die Gesamtanordnung wird nach unten weiter getaktet, bis die Transportorgane in Eingriff mit dem nächst oberen Gegenstand gelangen. Für diesen wiederholt sich dann der beschriebene Vorgang, wobei dann die Hebevorrichtung 59 am nächst oberen Tablett angreift und dieses sowie ggf. auf diesem aufliegende weitere Tabletts anhebt. Es kann auch so sein, daß durch eine geeignete Greifeinrichtung 59 abgehobene Tabletts zu einem neben der Speicheranordnung angeordneten Stapel verfahren und doch abgelegt werden, wie es in Fig. 8 und 9 dargestellt ist.

Die Beschickung einer Stapelanordnung kann sinngemäß von oben nach unten erfolgen, wobei vorzugsweise die Greifeinrichtung 59 zum Anheben von Tabletts oder Tablettstapeln sukzessive weiter unten liegende Tabletts ergreift und diese sowie die darauf liegenden Tabletts vom Reststapel abhebt.

## Patentansprüche

1. Einrichtung für das Beladen und Entladen bei der Behandlung von plattenförmigen Gegenständen, insbesondere von Leiterplatten und Formätzteilen, mit mindestens einer Speicheranordnung (2; 50) mit mehreren bezogen auf eine Stapelrichtung (3) aufeinanderfolgenden Speicherplätzen (4; 58) zur Aufnahme mindestens eines plattenförmigen Gegenstandes (5), dadurch gekennzeichnet, daß die Speicheranordnung (2; 50) mehrere von der Speicheranordnung und/oder voneinander lösbare Auflagen (6, 51) aufweist, die derart anordenbar sind, daß zwischen in Stapelrichtung aufeinanderfolgenden Auflagen ein Speicherplatz gebildet ist.

2. Einrichtung nach Anspruch 1, dadurch gekennzeichnet, daß die Auflagen (6; 51) zur Bildung einer im wesentlichen ausschließlich aus den Auflagen bestehenden Speicheranordnung (2; 50) aufeinander stapelbar ausgebildet sind.

3. Einrichtung nach Anspruch 1, oder 2, dadurch gekennzeichnet, das die Auflagen (6; 51) Fixiereinrichtungen (11,12;55,57) zur gegenseitigen Fixierung aufeinanderliegender Auflagen gegen Relativverschiebung quer zur Stapelrichtung (3) und oder Zentriereinrichtungen (11,12; 55,57) zur gegenseitigen Zentrierung aufeinanderliegender Auflagen aufweisen, wobei vorzusweise eine Fixiereinrichtung oder eine Zentriereinrichtung mindestens einen an einer Auflage vorgesehenen Vorsprung (11) aufweist, der zum Zusammenwirken mit einer den Vorsprung aufnehmenden Öffnung (12) einer benachbarten Auflage ausgebildet ist.

4. Einrichtung nach einem der vorhergehenden Ansprüche dadurch gekennzeichnet, daß mindestens ein Speicherplatz (4; 58) einer Speicheranordnung (2; 50) eine veränderliche Größe, insbesondere eine veränderliche Höhe hat, wobei vorzugsweise ein Abstand benachbarter Auflagen (6; 51) vorzugsweise stufenlos veränderbar ist.

5. Einrichtung nach einem der vorhervorgehenden Ansprüche, daher gekennzeichnet, die Speicheranordnung derart ausgebildet ist, daß mindestens ein Transportorgan (24; 32; 42) einer der Speicheranordnung zugeordneten Transporteinrichtung (20; 30; 40) zur Beschickung und Entleerung von Speicherplätzen in die Speicheranordnung einführbar ist und daß das Transportorgan im eingeführten Zustand durch Relativbewegung von Speicheranordnung (2; 50) und Transportorgan (24; 32; 42) in Stapelrichtung (3) zwischen Speicherplätzen (4; 58) bewegbar ist.

6. Einrichtung nach einem der vorhergehenden Anspruch, dadurch gekennzeichnet, daß eine Auflage (6; 51), insbesondere alle Auflagen einer Stapelanordnung, mindestens eine in Stapelrichtung (3) durchgehende Durchbrechung (14; 54) zum Hindurchführen mindestens eines Transportorganes (24; 32; 42) hat, wobei die Durchbrechung vorzugsweise zu mindestens einer Seite (8) der Auflage (6; 51) offen ist.

7. Einrichtung nach einem der vorhergehenden Ansprüche, dadurch gekennzeichnet, daß eine Auflage (6; 51) kammartig angeordnete, an einem Längsende untereinander verbundene Auflagearme (13; 52) hat, zwischen denen langgestreckte Durchbrechungen (14; 54) vorgesehen sind, wobei vorzugsweise die Auflagearme (13; 52) seitlich abgerundete, vorzugsweise ebene Auflageflächen (16) haben, und/oder wobei die Auflagearme (13) durch verwindungsteife Rohre mit rechteckigen Querschnitt gebildet sind.

8. Einrichtung nach einem der vorhergehenden Ansprüche, dadurch gekennzeichnet, daß ein vorzugsweise im wesentlichen rechtwinklig begrenzter Speicherplatz (4; 58) an mindestens zwei Seiten (9, 10), insbesondere an drei Seiten (8, 9, 10) quer zur Stapelrichtung zur Hindurchführung von plattenförmigen Gegenständen offen oder öffenbar ist.

9. Einrichtung nach einem der vorhergehenden Ansprüche dadurch gekennzeichnet, daß eine vorzugsweise oberhalb der Speicheranordnung (2; 50) anordenbare Einrichtung (59) zum Anheben und/oder Umsetzen von lösbaren Auflagen (6; 51) vorgesehen ist, wobei die Einrichtung vorzugsweise derart ausgebildet ist, daß eine Auflage an mindestens einer Seite, vorzugsweise an zwei gegenüberliegenden Seiten erfaßbar und/oder untergreifbar ist und/oder daß eine Bewegungseinrichtung, insbesondere eine Hub- und Senkeinrichtung zur vorzugsweise taktweisen Bewegung der Speicheranordnung (2; 50) in vorzugsweise vertikaler Stapelrichtung (3) vorgesehen ist.

10. Einrichtung nach einem der Ansprüche 5 bis 9, dadurch gekennzeichnet, daß die Transporteinrichtung (20; 30; 40) eine Anordnung (21; 31; 41) von Transportorganen (24; 32; 42) hat, die derart komplementär zu den Durchbrechungen (14; 54) der Auflagen (6; 51) angeordnet sind, daß die Speicheranordnung (2; 50) und die Transporteinrichtung unter Hindurchführung von Transportorganen (24; 32; 42) durch die Durchbrechungen (14; 51) in Stapelrichtung (3) relativ zueinander bewegbar sind.

11. Einrichtung nach einem der vorhergehenden Ansprüche, dadurch gekennzeichnet, daß die Transporteinrichtung (20; 30; 40) mindestens eine Transportorgananordnung (21; 31; 41) mit kammartig angeordneten, vorzugsweise parallel mit Abstand zueinander verlaufenden Transportorganen (24; 32; 42) hat.

12. Einrichtung nach einem der vorhergehenden Ansprüche, dadurch gekennzeichnet, daß die Transporteinrichtung (20) eine vorzugsweise gabelartig ausgebildete Transportorgananordnung (21) hat, die zur Beschickung und Entleerung von Speicherplätzen als Ganzes quer, insbesondere senkrecht zur Stapelrichtung (3) hin- und herbewegbar ist.

13. Einrichtung nach einem der vorhergehenden Ansprüche, dadurch gekennzeichnet, daß die Transporteinrichtung (30; 40) mindestens eine Transportanordnung (31; 41) mit beweglich antreibbaren Transportgliedern (23; 42) zum Transport von plattenförmigen Gegenständen relativ zur Transportorgananordnung quer zur Stapelrichtung (3) aufweist, wobei vorzugsweise die Transportglieder mindestens eine Rolle und/oder Walze (42) aufweisen, die vorzugsweise um eine in Längsrichtung der Transportorgane verlaufende Achse drehbar ist und/oder wobei die Transportglieder mindestens ein Förderband (23) aufweisen, das vorzugsweise in Längsrichtung eines Transportorgans ausgerichtet und antreibbar ist.

14. Speicheranordnung mit mehreren bezogen auf eine Stapelrichtung (3) aufeinanderfolgenden Speicherplätzen (4; 58) zur Aufnahme mindestens eines plattenförmigen Gegenstandes (5), insbesondere zur Verwendung bei einer Einrichtung nach einem der vorhergehenden Ansprüche, wobei die Speicheranordnung mehrere von der Speicheranordnung und/oder voneinander lösbare Auflagen (6; 51) aufweist, die derart anordenbar sind, daß zwischen in Stapelrichtung aufeinanderfolgenden Auflagen ein Speicherplatz gebildet ist.

15. Speicheranordnung nach Anspruch 14, gekennzeichnet durch mindestens eines der Merkmale des kennzeichnenden Teils von mindestens einem der Ansprüche 2 bis 8.

16. Auflage zur Bildung einer Speicheranordnung nach einem der Ansprüche 14 oder 15.

17. Auflage nach Anspruch 16, gekennzeichnet durch mindestens einer der Merkmale des kennzeichenden Teil von mindestens einem der Ansprüche 2 bis 3 oder 6 bis 7.
